# EUROPÄISCHE PATENTSCHRIFT

(11) **EP 2 369 624 B1**
(45) Veröffentlichungstag und Bekanntmachung des Hinweises auf die Patenterteilung: **22.08.2018**
(21) Anmeldenummer: 11154628.9
(22) Anmeldetag: 16.02.2011
(51) Int. Cl.: H01L 25/11, H01L 23/00, H01L 23/36

(54) **Vorrichtung zur Positionierung eines Leistungshalbleiters**
Device for positioning a power semiconductor
Dispositif destiné au positionnement d'un semi-conducteur de puissance

(30) Priorität: 27.03.2010 DE 102010013165
(43) Veröffentlichungstag der Anmeldung: 28.09.2011
(73) Patentinhaber: GE Energy Power Conversion Technology Limited, Rugby Warwickshire CV21 1BU (GB)
(72) Erfinder: Pelz, Andreas, 10318, Berlin (DE); Greiner, Jan, 13187, Berlin (DE)
(74) Vertreter: Serjeants LLP

(56) Entgegenhaltungen:
- EP-B1- 0 102 654
- FR-A- 1 484 076
- JP-A- 6 177 293
- JP-A- 54 112 172
- JP-A- 2002 246 543

## Beschreibung

Die Erfindung betrifft eine Vorrichtung zur Positionierung eines Leistungshalbleiters nach dem Oberbegriff des Anspruchs 1.

Leistungshalbleiter werden beispielsweise zum Bau von Stromrichteranlagen verwendet. Hierzu sind die Leistungshalbleiter beispielsweise als Thyristoren ausgeführt.

Scheibenzellen als Bauform von Leistungshalbleitern sind ebenfalls bekannt.

Für eine ordnungsgemäße Funktion des Leistungshalbleiters muss dieser an einer vorgegebenen Position zu einem Aufnahmekörper positioniert werden und an den Aufnahmekörper mit einer Kraft angepresst werden. Der Aufnahmekörper ist üblicherweise zur Kühlung des Leistungshalbleiters ausgebildet.

Ebenfalls bekannt sind Zentrierstifte, die orthogonal und mittig zu einer Kontaktfläche des Leistungshalbleiters und orthogonal und mittig zu einer Oberfläche des Aufnahmekörpers angebracht werden, um den Leistungshalbleiter auf dem Aufnahmekörper zu positionieren. Die Zentrierstifte erzwingen ein An- bzw. Abheben des Leistungshalbleiters von der Oberfläche des Aufnahmekörpers. Bei einem Aufsetzen des Leistungshalbleiters auf die Oberfläche des Aufnahmekörpers besteht das Risiko, dass die Kontaktfläche des Leistungshalbleiters beschädigt wird.

Die europäische Patentschrift EP 0 102 654 B1 zeigt eine horizontalachsige Stromrichteranordnung mit einer Mehrzahl von mechanisch in Reihe geschalteten Halbleiterbauelementen mit planparallelen Kontaktflächen und zwischengeschalteten Kühlelementen mit gleichfalls planparallelen Kontaktflächen. Im Bereich unterhalb zweier benachbarter Kühlelemente ist ein Abstützteil vorgesehen. Das Abstützteil stützt sich auf zwei horizontal benachbarten Spannbolzen ab. Das Abstützteil weist Zentrier- bzw. Justierkanten und/oder -flächen auf. Diese weisen gegen das Halbleiterbauelement und das Kühlelement und dienen zur zumindest zeitweiligen Abstützung von Halbleiterbauelement und/oder Kühlelement.

Die deutsche Gebrauchsmusterschrift G 92 18 106.6 zeigt eine Anordnung zur Zentrierung bei druckkontaktierten Scheibenhalbleitern. Vertiefungen in Anschlussschienen von Potentialanschlüssen sind durch verformende Bearbeitung eingeprägt oder eingedrückt. Es sind zusätzliche Mittel vorgesehen, mit denen für eine Säulen- oder Stapelbildung mehrerer Scheibenhalbleiter die verschiedenen Anschlussschienen in eine ausgerichtete Position bringbar sind.

Weiterer Stand der Technik geht aus JP 2002 24 6543, JP 6 177 293, EP 102 654, JP 54 112 172 und FR 1 484 076 hervor. Ausgehend von dem beschriebenen Stand der Technik liegt der vorliegenden Erfindung die Aufgabe zu Grunde, eine Vorrichtung zur Positionierung des Leistungshalbleiters derart auszugestalten, dass eine Positionierung des Leistungshalbleiters möglichst exakt und mit möglichst geringem Aufwand realisiert werden kann. Die Aufgabe wird durch eine Vorrichtung nach dem Anspruch 1 gelöst.

Vorteilhaft kann durch die erfindungsgemäße Vorrichtung eine Beschädigung der Kontaktfläche des Leistungshalbleiters bzw. der Oberfläche des Aufnahmekörpers zur Aufnahme des Leistungshalbleiters vermieden werden. Dies ist durch einen Ein- bzw. Ausschub des Leistungshalbleiters in einer Ebene möglich. Durch Vermeidung von Beschädigungen kann die Betriebssicherheit erhöht und die Fehleranfälligkeit verringert werden.

Vorteilhaft wird der Randbereich, der bereits vom Hersteller des Leistungshalbleiters mit geringer Toleranz gefertigt wird, zu einer Positionierung des Leistungshalbleiters herangezogen. Durch die Auswahl des Randbereichs mit geringer Toleranz kann eine Positionierung sehr exakt durchgeführt werden.

Bei Einsatz der erfindungsgemäßen Vorrichtung innerhalb einer Stromrichteranordnung ist vorteilhaft nur ein geringer Hub zur Demontage und folgenden Montage des Leistungshalbleiters oder des Aufnahmekörpers nötig. Eine Verringerung des Montagehubs trägt vorteilhaft zur Stabilität der Stromrichteranordnung während der Wartungsarbeiten bei. Vorteilhaft können somit die Wartungsarbeiten schneller, präziser und sicherer durchgeführt werden.

Bei der Erfindung ist das Positioniermittel auf dem Aufnahmekörper angeordnet. Dadurch vereinfacht sich die Befestigung des Positioniermittels.

In einer vorteilhaften Ausführungsform der Vorrichtung ist ein ganzflächiger Kontakt zwischen dem Aufnahmekörper und dem Leistungshalbleiter vorgesehen, um den Leistungshalbleiter auf dem Aufnahmekörper zu bewegen. Beim Herausziehen des Leistungshalbleiters herrschen damit geringe Ablösekräfte und das Herausziehen des Leistungshalbleiters wird vereinfacht. Beim Einführen des Leistungshalbleiters muss dieser nicht über den Aufnahmekörper angehoben werden, sondern kann aufliegend auf dem Aufnahmekörper geführt werden.

In einer weiteren vorteilhaften Weiterbildung der Vorrichtung schließt das Positioniermittel einen inneren Winkel größer 90° und kleiner 180° ein. Wird nun der Leistungshalbleiter auf das Positioniermittel geschoben, so wird der Leistungshalbleiter mit Hilfe des Positioniermittels und den Kräften, die die Einschubbewegung verursachen, in die gewünschte Position gezwungen.

Bei der Erfindung umfasst das Positioniermittel eine den Randbereich des Leistungshalbleiters aufnehmende gekrümmte Kante. Die aufnehmende Kante gibt die gewünschte Position für den Leistungshalbleiter genau vor und verhindert eine Beschädigung des Leistungshalbleiters.

Bei der Erfindung ist das Positioniermittel als Anschlagblech ausgeführt. Dadurch können beispielsweise Standardelemente als Aufnahmekörper mit dem Anschlagblech als Positioniermittel versehen werden. Weitergehend ist auch eine Nachrüstung bestehender Systeme möglich. Außerdem zeichnet sich das Anschlagblech durch eine einfache Fertigung aus.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Es werden für funktionsäquivalente Elemente in allen Figuren die gleichen Bezugszeichen verwendet.

In der Zeichnung zeigen
- Figur 1: eine Leistungshalbleiter-Kühlkörper-Anordnung;
- Figur 2: eine Stromrichteranordnung;
- Figur 3: eine erste und eine zweite Ausführungsform einer Vorrichtung zur Positionierung eines Leistungshalbleiters;
- Figur 4: ein Anschlagblech als Teil der ersten Ausführungsform der Vorrichtung zur Positionierung des Leistungshalbleiters.

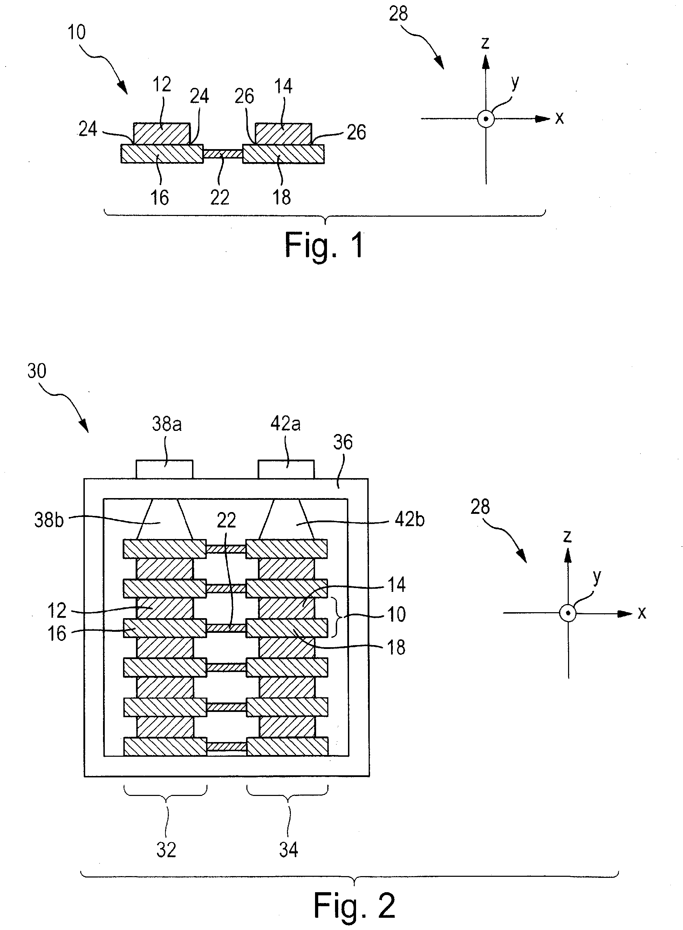

Figur 1 zeigt eine Leistungshalbleiter-Kühlkörper-Anordnung 10 mit Leistungshalbleitern 12 und 14, Kühlkörpern 16 und 18 und einem Mittenteil 22. Die Kühlkörper 16 und 18 werden allgemein auch als Aufnahmekörper bezeichnet. Die beiden Kühlkörper 16 und 18 sind über das Mittenteil 22 elektrisch leitend verbunden. Das Mittenteil 22 verbindet die beiden Kühlkörper üblicherweise fest miteinander. Die Verbindung kann aber auch eine gewisse Flexibilität aufweisen. Die Kühlkörper 16 und 18 dienen dazu, thermische Energie aus den Leistungshalbleitern 12 und 14 abzuführen. Die Kühlkörper 16 und 18 dienen außerdem dazu, die Leistungshalbleiter 12 und 14 zu tragen sowie eine elektrisch leitende Verbindung zu den Leistungshalbleitern 12 und 14 in Kontaktbereichen 24 und 26 herzustellen.

Die Leistungshalbleiter 12 und 14 sind üblicherweise Halbleiterbauelemente und beispielsweise als Diode oder Thyristor ausgeführt. Daneben können die Leistungshalbleiter 12 und 14 auch als Insulated-Gate Bipolar Transistor, IGBT, als Gate Turn-OFF Thyristor, GTO, oder als Integrated Gate Commutated Thyristor, IGCT, ausgeführt sein.

Üblicherweise sind die Leistungshalbleiter 12 und 14 zwischen Befestigungsmitteln eingeklemmt. Unter Außerachtlassen möglicher Positioniermittel wirkend in der xy-Ebene werden die Leistungshalbleiter 12 und 14 durch eine im Wesentlichen konstante Kraft in Richtung einer z-Achse eines kartesischen Koordinatensystems 28 auf den Kühlkörpern 16 und 18 befestigt, wobei die Kraft von den Befestigungsmitteln ausgeht. Durch die Krafteinwirkung in Richtung der z-Achse ohne vorhandene Positioniermittel besteht eine formschlüssige Verbindung in beiden Richtungen der z-Achse aufgrund des Einklemmens zwischen den Befestigungsmitteln, d.h. den Kühlkörpern 16 und 18,und eine kraftschlüssige Verbindung in der xy-Ebene des kartesischen Koordinatensystems 28 zwischen dem Leistungshalbleiter 12 bzw. 14 und dem Kühlkörper 16 bzw. 18, da das Aneinanderpressen eine Haftreibung zur Folge hat.

Zur Herstellung und Aufrechterhaltung eines elektrischen und thermischen Kontakts zwischen dem Leistungshalbleiter 12 bzw. 14 und dem Kühlkörper 16 bzw. 18 müssen durch den Hersteller des Leistungshalbleiters 12 bzw. 14 vorgegebene Kräfte, die in Richtung der z-Achse auf den Leistungshalbleiter 12 bzw. 14 einwirken, eingehalten werden.

Die Funktion des Leistungshalbleiters 12 bzw. 14 hängt von einem ganzflächigen Kontakt zwischen dem Leistungshalbleiter 12 bzw. 14 und dem Kühlkörper 16 bzw. 18 in dem Kontaktbereich 24 bzw. 26 ab. Zusätzlich darf die Position des Leistungshalbleiters 12 bzw. 14 auf dem Kühlkörper 16 bzw. 18 im Wesentlichen nicht verlassen werden.

Zwischen dem Leistungshalbleiter 12 bzw. 14 und dem Kühlkörper 16 bzw. 18 ist in dem Kontaktbereich 24 bzw. 26 üblicherweise eine Wärmeleitpaste bzw. ein Kontaktfett eingebracht, um die thermische und elektrische Verbindung zwischen dem Leistungshalbleiter 12 bzw. 14 und dem Kühlkörper 16 bzw. 18 zu gewährleisten oder zu verbessern.

Des Weiteren dürfen der Leistungshalbleiter 12 bzw. 14 und der Kühlkörper 16 bzw. 18 in dem Kontaktbereich 24 bzw. 26 nicht beschädigt sein, noch dürfen in diesem Bereich Ablagerungen existieren, um die thermische und elektrische Verbindung zwischen dem Leistungshalbleiter 12 bzw. 14 und dem Kühlkörper 16 bzw. 18 zu gewährleisten und um weiteren Beschädigungen vorzubeugen.

Der Leistungshalbleiter 12 bzw. 14 ist im Bereich des Kontaktbereichs 24 bzw. 26 üblicherweise aus Kupfer gefertigt. Kupfer ist leicht deformierbar und damit der Leistungshalbleiter 12 bzw. 14 auch leicht beschädigbar.

Der zur Kühlung des Leistungshalbleiters 12 bzw. 14 vorgesehene Kühlkörper 16 bzw. 18 kann unterschiedlich ausgebildet sein. Zu einer passiven Kühlung des Leistungshalbleiters 12 bzw. 14 besteht der Kühlkörper 16 bzw. 18 aus einem wärmeleitfähigen Material, das Wärmeenergie von dem Leistungshalbleiter 12 bzw. 14 aufnehmen und an die Umgebung abgeben kann. Bei entsprechender Ausgestaltung des Kühlkörpers 16 bzw. 18 ist eine aktive Luftkühlung durch einen Ventilator, eine Wasserkühlung oder aber auch eine Ölkühlung möglich.

Figur 2 zeigt eine Stromrichteranordnung 30 bestehend aus einer Mehrzahl von Leistungshalbleiter-Kühlkörper-Anordnungen 10, die übereinander angeordnet sind. Eine Leistungshalbleiter-Kühlkörper-Anordnung 10 umfasst die anhand Figur 1 erläuterten Elemente. Die Leistungshalbleiter-Kühlkörper-Anordnungen 10 bilden in Richtung der z-Achse Säulen 32 und 34. Die Richtung der z-Achse weist entgegen der Gewichtskraft. Ein Montagerahmen 36 beaufschlagt unter Zuhilfenahme von Spannvorrichtungen die Säulen 32 und 34 in Richtung der z-Achse mit Kräften, so dass die Leistungshalbleiter 12 bzw. 14 zwischen den Kühlkörpern 16 bzw. 18 eingeklemmt sind.

Ein Spannmittel 38a bzw. 42a ergibt zusammen mit den Spannkörpern 38b bzw. 42b die genannte Spannvorrichtung. Hierzu steht das Spannmittel 38a bzw. 42a in einer Wirkverbindung mit dem Spannkörper 38b bzw. 42b. Das Spannmittel 38a bzw. 42a ist derart betätigbar, dass die Kraft, die der Spannkörper 38b bzw. 42b auf die Säule 32 bzw. 34 beaufschlagt, variiert werden kann. Hierbei sind im Wesentlichen zwei Zustände zu unterscheiden. Ein gespannter Zustand der Spannvorrichtung entspricht einer hohen Kraft in negativer Richtung der z-Achse, der entspannte Zustand entspricht einer geringen Kraft in negativer Richtung der z-Achse.

Zwischen der obersten Leistungshalbleiter-Kühlkörper-Anordnung 10 und den Spannvorrichtungen sind zwei weitere Kühlkörper 16 und 18 in die Säulen 32 und 34 eingebracht.

Im Allgemeinen ist zu einem Austausch des Leistungshalbleiters 12 bzw. 14 oder der beiden Kühlkörper 16 und 18 vorgesehen, dass die Spannvorrichtungen derart entspannt werden, dass ein Anheben in positiver Richtung der z-Achse von beispielsweise den Kühlkörpern 16 und 18 der Säulen 32 und 34 mit Hilfe einer nicht dargestellten Wechselvorrichtung ermöglicht wird. Ist ein Hub an der entsprechenden Stelle groß genug, dann kann beispielsweise der Leistungshalbleiter 12 aus der Säule 32 entnommen und ersetzt werden. Nach dem Einführen und Positionieren des neuen Leistungshalbleiters 12 können die durch den Hub angehobenen Kühlkörper 16 und 18 und die oberhalb liegenden Leistungshalbleiter 12 und 14 durch die Wechselvorrichtung wieder abgesenkt werden. Die Spannvorrichtungen werden wieder gespannt und beaufschlagen damit die Säulen 32 und 34 in negativer Richtung der z-Achse mit Kräften.

Eine bekannte, nicht dargestellte Vorrichtung zur Positionierung des Leistungshalbleiters 12 bzw. 14 sieht vor, dass ein nicht dargestellter Zentrierstift auf jedem der Kühlkörper 16, 18 angebracht ist. Die Längsachse des Zentrierstifts ist in Richtung der z-Achse ausgerichtet. Die Leistungshalbleiter 12, 14 weisen jeweils eine mittige Bohrung auf, in die der jeweilige Zentrierstift eingeführt wird und der Leistungshalbleiter 12 bzw. 14 auf dem Kühlkörper 16 bzw. 18 positioniert werden kann. Bei einem Wartungsvorgang, der den Austausch eines Leistungshalbleiters 12 bzw. 14 vorsieht, ist ein Hub derart groß vorzunehmen ist, dass der Leistungshalbleiter 12 bzw. 14 in positiver Richtung der z-Achse angehoben werden kann, um von der Kontaktfläche des Kühlelements 16 bzw. 18 und dem Zentrierstift entfernt zu werden. Ein umgekehrtes Vorgehen gilt entsprechend für die Einführung eines neuen Leistungshalbleiters 12 bzw. 14 in eine der Säulen 32 oder 34.

Die Vorrichtung zur Positionierung des Leistungshalbleiters 12 bzw. 14 sieht die Entnahme und die Einführung des Leistungshalbleiters 12 bzw. 14 im Wesentlichen in einer Ebene vor, wobei der Leistungshalbleiter 12 bzw. 14 zur Positionierung bei der Einführung im Wesentlichen nicht über der Oberfläche des Kühlkörpers 16 bzw. 18 angehoben werden muss.

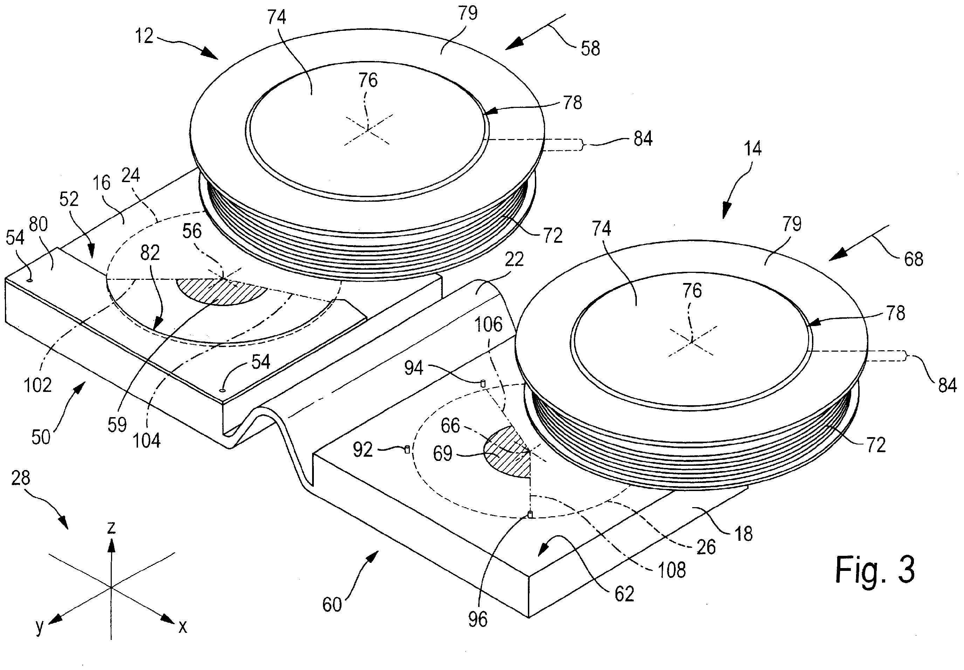

Figur 3 zeigt eine erste erfindungsgemäße Ausführungsform 50 der Vorrichtung zur Positionierung des Leistungshalbleiters 12 und, als Beispiel, der nicht Teil der Erfindung ist, eine zweite Ausführungsform 60 der Vorrichtung zur Positionierung des Leistungshalbleiters 14.

Die Leistungshalbleiter 12 und 14 weisen einen gleichartigen Aufbau auf. Die Leistungshalbleiter 12 und 14 sind als eine Scheibenzelle ausgeführt. Die Leistungshalbleiter 12 und 14 besitzen ein im Wesentlichen zylindrisches Zellengehäuse, wobei eine Höhe in der z-Achse des zylindrischen Zellengehäuses geringer ist als der Durchmesser des zylindrischen Zellengehäuses in der xy-Ebene. Im Bereich eines Mantels der Leistungshalbleiter 12 und 14 befindet sich ein Keramikgehäuse 72, welches üblicherweise zylinderringförmig ausgebildet ist. Eine Ober- und Unterseite der Leistungshalbleiter 12 und 14 sind im Wesentlichen gleich ausgebildet und, als Ebene betrachtet, orthogonal zu der z-Achse des kartesischen Koordinatensystems 28. Die Ober- und Unterseiten der Leistungshalbleiter 12 und 14 weisen jeweils eine kreisrunde Kontaktfläche 74 auf. Die Kontaktfläche 74 ist im Wesentlichen eben. Die Kontaktfläche 74 besitzt einen Mittelpunkt 76. Die Kontaktfläche 74 ist durch einen Randbereich 78 radial begrenzt.

Des Weiteren weisen die Ober- und Unterseite der Leistungshalbleiter 12 und 14 einen äußeren Blechring 79 radial außerhalb des Randbereichs 78 der Kontaktfläche 74 auf. Die Kontaktfläche 74 und der Blechring 79 sind durch einen Abstand 84 in Richtung der z-Achse derart beabstandet, dass bei einem Anliegen des Leistungshalbleiters 12 bzw. 14 an einer zu der Ober- oder Unterseite des Leistungshalbleiters 12 bzw. 14 parallelen Ebene nur die Kontaktfläche 74 mit der parallelen Ebene kontaktiert ist.

Üblicherweise ist die eine Kontaktfläche 74 des Leistungshalbleiters 12 bzw. 14 eine Kathode und die andere Kontaktfläche 74 des Leistungshalbleiters 12 bzw. 14 eine Anode.

Die erste Ausführungsform 50 der Vorrichtung zur Positionierung des Leistungshalbleiters 12 weist ein auf einer Oberfläche 52 des Kühlkörpers 16 angebrachtes Anschlagblech 80 auf. Die Oberfläche 52 ist im Wesentlichen eben. Das Anschlagblech 80 ist über Bohrungen 54 und entsprechende Befestigungsmittel auf der Oberfläche 52 des Kühlkörpers 16 befestigt. Das Anschlagblech 80 kann auch als Teil des Kühlkörpers 16 ausgebildet sein.

Das Anschlagblech 80 weist eine Höhe kleiner als die Höhe 84 in Richtung der z-Achse auf. Das Anschlagblech 80 ist derart auf der Oberfläche 52 des Kühlkörpers 16 angebracht, dass bei ganzflächigem Kontakt des Kühlkörpers 16 mit dem Leistungshalbleiter 12 im Bereich einer der Kontaktflächen 74 und der Oberfläche 52 die Bewegung des Leistungshalbleiters 12 in der xy-Ebene beschränkt wird. Dazu weist das Anschlagblech 80 eine gekrümmte Kante 82 auf, die dem Randbereich 78 des Leistungshalbleiters 12 entspricht und diesen aufnehmen kann.

Die gekrümmte Kante 82 des Anschlagblechs 80 bildet auf der Oberfläche 52 des Kühlkörpers 16 den Kontaktbereich 24 mit einem Mittelpunkt 56. Der Kontaktbereich 24 entspricht hinsichtlich seiner Fläche und Form der Kontaktfläche 74.

Zur Positionierung des Leistungshalbleiters 12 gemäß der ersten Ausführungsform 50 der Vorrichtung zur Positionierung wird der Leistungshalbleiter 12 mit seiner Kontaktfläche 74 so auf die Oberfläche 52 des Kühlkörpers 16 gelegt, dass sich die Kontaktfläche 74 und die Oberfläche 52 teilweise überschneiden. Hierbei sind die Kontaktfläche 74 und die Oberfläche 52 im Wesentlichen parallel zueinander ausgerichtet. Wird nun der Leistungshalbleiter 12 im Wesentlichen unter vorgenanntem Aufliegen der Kontaktfläche 74 des Leistungshalbleiters 12 auf der Oberfläche 52 des Kühlkörpers 16 in einer Einschubrichtung 58 bewegt, so sorgt das Anschlagblech 80 in Verbindung mit der Kraft, die die Schiebebewegung verursacht, dafür, dass mindestens ein Teil des Randbereichs 78 an dem Anschlagblech 80 anliegt. Mit einer weiteren Schiebebewegung und dem folgenden gesamten Anliegen des Randbereichs 78 an der gekrümmten Kante 82 liegt die gesamte Kontaktfläche 74 des Leistungshalbleiters 12 auf dem Kontaktbereich 24 des Kühlkörpers 16. Ausgehend vom Mittelpunkt 76 des Leistungshalbleiters 12 herrscht in Richtung des an dem Anschlagblechs 80 anliegenden Randbereichs 78 Formschluss. Die Mittelpunkte 56 und 76 liegen damit auf einer Geraden parallel zur z-Achse. Der Leistungshalbleiter 12 ist somit zentriert auf dem Kühlkörper 16 positioniert.

Die zweite Ausführungsform 60 der Vorrichtung zur Positionierung des Leistungshalbleiters 14, die nicht Teil der Erfindung ist, weist drei Passstifte 92, 94 und 96, angebracht auf einer Oberfläche 62 des Kühlkörpers 18, auf. Die Oberfläche 62 ist im Wesentlichen eben. Die drei Passstifte 92, 94 und 96 begrenzen analog zur Funktion des Anschlagblechs 80 einen Kontaktbereich 26 mit einem Mittelpunkt 66. Der Mittelpunkt 66 ist gleichzeitig Mittelpunkt der Oberfläche 62 des Kühlkörpers 18. Die Passstifte 92, 94 und 96 können entweder in den Kühlkörper 18 eingebracht sein oder auch an dem Kühlkörpers 18 ausgebildet sein. Die Passstifte 92, 94 und 96 definieren Kontaktpunkte für den Randbereich 78 des Leistungshalbleiters 14. Die Passstifte 92, 94 und 96 weisen eine Höhe kleiner als die Höhe 84 in Richtung der z-Achse auf.

Die Passstifte 92, 94 und 96 sind beispielweise als im Wesentlichen zylinderförmige Körper ausgebildet.

Ebenso ist es möglich, nur 2 der 3 Passstifte 92, 94 und 96 vorzusehen, um den Kontaktbereich 26 zu definieren.

Die Positionierung durch die zweite Ausführungsform 60 erfolgt im Wesentlichen analog zu den Erläuterungen zur ersten Ausführungsform 50 der Vorrichtung zur Positionierung. Wird nun der Leistungshalbleiter 14 in einer Einschubrichtung 68 bei im Wesentlichen ganzflächigem Kontakt der Oberfläche 62 mit der Kontaktfläche 74 des Leistungshalbleiters 14 geschoben, dann begrenzen die Passstifte 92, 94 und 96 die Bewegung des Leistungshalbleiters 14 in der xy-Ebene. Überlappen sich der Kontaktbereich 26 und die Kontaktfläche 74 ganz, dann liegen die Mittelpunkte 66 und 76 auf einer Geraden parallel zur z-Achse. Ausgehend vom Mittelpunkt 76 des Leistungshalbleiters 14 herrscht in Richtung des an den Passstifte 92, 94 und 96 anliegenden Randbereichs 78 Formschluss. Damit ist der Leistungshalbleiter 14 zentriert zu dem Kühlkörper 18 positioniert.

Das Anschlagblech 80 schließt über 2 Schenkel 102 und 104, die sich jeweils ausgehend von Endpunkten der gekrümmten Kante 82 in dem Mittelpunkt 56 treffen, einen inneren Winkel 59 ein.

Die Passstifte 92, 94 und 96 schließen über Schenkel 106 und 108, die sich jeweils ausgehend von den Passstiften 94 und 96 in dem Mittelpunkt 66 treffen, einen inneren Winkel 69 ein.

Die inneren Winkel 59 und 69 sind stumpfe Winkel, d.h. die inneren Winkel 59 und 69 sind kleiner als ein halber Vollwinkel und größer als ein Viertel eines Vollwinkels. Ein innerer stumpfer Winkel 59 bzw. 69 beschränkt die Bewegungsfreiheit eines zentriert positionierten Leistungshalbleiters 12 bzw. 14 in radial von den Mittelpunkten 56 bzw. 66 ausgehenden Bewegungsrichtungen in der xy-Ebene. Ein äußerer, nicht dargestellter Winkel, der gemeinsam mit dem inneren Winkel 59 bzw. 69 einen Vollwinkel ergibt, beschränkt die Bewegungsfreiheit eines zentriert positionierten Leistungshalbleiters 12 bzw. 14 in radial von den Mittelpunkten 56 bzw. 66 ausgehenden Bewegungsrichtungen in der xy-Ebene nicht.

Beide Ausführungsformen 50 und 60 der Positioniervorrichtung werden üblicherweise in Verbindung mit der zu Figur 2 beschriebenen Wechselvorrichtung verwendet. Ein Verfahren zum Austausch eines Leistungshalbleiters 12 bzw. 14 ergibt sich entsprechend den Ausführungen zu Figur 2.

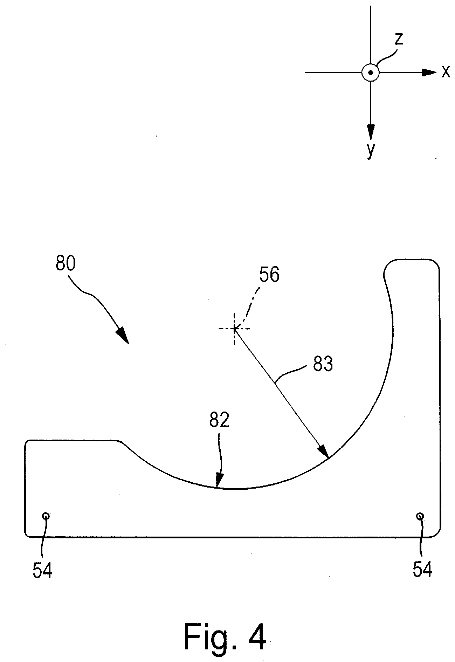

Figur 4 zeigt das Anschlagblech 80. Das Anschlagblech 80 weist die Bohrungen 54 sowie die gekrümmte Kante 82 auf. Der Mittelpunkt 56, auf einer Parallelen zur z-Achse liegend, bestimmt mit einem Radius 83 die zylindrische Form gekrümmten Kante 82.

## Patentansprüche

1. Vorrichtung zur Positionierung eines Leistungshalbleiters (12) auf einem Aufnahmekörper (16), wobei der Leistungshalbleiter (12) einen Randbereich (78) aufweist, und wobei ein Positioniermittel vorgesehen ist, das dazu ausgebildet ist, den Randbereich (78) des Leistungshalbleiters (12) derart aufzunehmen, dass eine Bewegung des Leistungshalbleiters (12) im Bereich eines inneren Winkels (59) begrenzt ist, **dadurch gekennzeichnet, dass** das Positioniermittel ein auf der Oberfläche (52) des Aufnahmekörpers (16) angebrachtes Anschlagblech (80) ist, das eine den Randbereich (78) des Leistungshalbleiters (12) aufnehmende gekrümmte Kante (82) aufweist, wobei der innere Winkel (59) durch zwei Schenkel (102, 104), die sich jeweils ausgehend von Endpunkten der gekrümmten Kante (82) in dem Mittelpunkt (56) des Leistungshalbleiters (12) treffen, vorgegeben ist.

2. Vorrichtung nach Anspruch 1, wobei das Positioniermittel dazu ausgebildet ist, die Bewegung bei einem ganzflächigem Kontakt der Oberfläche (52) des Aufnahmekörpers (16) und der Kontaktfläche (74) des Leistungshalbleiters (12) zu begrenzen.

3. Vorrichtung nach einem der Ansprüche 1 oder 2, wobei der innere Winkel (59) größer 90° und kleiner 180° ist.

4. Vorrichtung nach einem der vorstehenden Ansprüche, wobei der Leistungshalbleiter die Bauform einer Scheibenzelle besitzt.

5. Vorrichtung nach einem der vorstehenden Ansprüche, wobei der Leistungshalbleiter (12) eine Diode, ein Thyristor, ein IGBT, ein GTO oder IGCT ist.

6. Vorrichtung nach einem der vorstehenden Ansprüche, wobei die Vorrichtung Teil einer Stromrichteranordnung ist.

## Claims

1. Device for positioning a power semiconductor (12) on a receiving body (16), wherein the power semiconductor (12) has an edge region (78), and wherein a positioning means is provided which is configured to receive the edge region (78) of the power semiconductor (12) such that a movement of the power semiconductor (12) in the region of an inner angle (59) is limited, **characterised in that** the positioning means is a stop plate (80) which is arranged on the surface (52) of the receiving body (16) and has a curved edge (82) receiving the edge region (78) of the power semiconductor (12), wherein the inner angle (59) is predefined by two legs (102, 104) which, starting from end points of the curved edge (82), meet at the centre point (56) of the power semiconductor (12).

2. Device according to claim 1, wherein the positioning means is configured to limit the movement on a full-surface contact of the surface (52) of the receiving body (16) and the contact face (74) of the power semiconductor (12).

3. Device according to claim 1 or 2, wherein the inner angle (59) is greater than 90° and less than 180°.

4. Device according to any of the preceding claims, wherein the power semiconductor has the form of a disc cell.

5. Device according to any of the preceding claims, wherein the power semiconductor (12) is a diode, a thyristor, an IGBT, a GTO or IGCT.

6. Device according to any of the preceding claims, wherein the device is part of a power converter arrangement.

## Revendications

1. Dispositif de positionnement d'un semi-conducteur de puissance (12) sur un corps de réception (16), le semi-conducteur de puissance (12) présentant une zone de bord (78), et un moyen de positionnement étant prévu, qui est agencé pour recevoir la zone de bord (78) du semi-conducteur de puissance (12) de manière telle qu'un mouvement du semi-conducteur de puissance (12) soit limité dans la plage d'un angle interne (59), **caractérisé en ce que** le moyen de positionnement est une plaque de butée (80) qui est montée sur la surface (52) du corps de réception (16) et présente un bord courbe (82) recevant la zone de bord (78) du semi-conducteur de puissance (12), l'angle interne (59) étant prédéterminé par deux côtés (102, 104) qui partent respectivement de points d'extrémité du bord courbe (82) et se rejoignent au centre (56) du semi-conducteur de puissance (12).

2. Dispositif selon la revendication 1, dans lequel le moyen de positionnement est conçu pour limiter le mouvement lors du contact sur la totalité des surfaces entre la surface (52) du corps de réception (16) et la surface de contact (74) du semi-conducteur de puissance (12).

3. Dispositif selon une des revendications 1 ou 2, dans lequel l'angle interne (59) est supérieur à 90° et inférieur à 180°.

4. Dispositif selon l'une des revendications précédentes, dans lequel le semi-conducteur de puissance présente la forme de construction d'un boîtier à disque.

5. Dispositif selon l'une des revendications précédentes, dans lequel le semi-conducteur de puissance (12) est une diode, un thyristor, un IGBT, un GTO ou un IGCT.

6. Dispositif selon l'une des revendications précédentes, dans lequel le dispositif fait partie d'un montage convertisseur de courant.
